(19) Europäisches Patentamt
European Patent Office
Office européen des brevets

(11) **EP 2 530 482 B1**

(12) **EUROPEAN PATENT SPECIFICATION**

(45) Date of publication and mention
of the grant of the patent:
**20.03.2024   Bulletin 2024/12**

(21) Application number: **12169994.6**

(22) Date of filing: **30.05.2012**

(51) International Patent Classification (IPC):
**G01R 31/36** (2020.01)       **H01M 10/00** (2006.01)
**G01R 31/367** (2019.01)      **H01M 4/485** (2010.01)
**H01M 10/0525** (2010.01)    **H01M 10/48** (2006.01)

(52) Cooperative Patent Classification (CPC):
**G01R 31/367;** G01R 31/389; G01R 31/392;
H01M 4/485; H01M 10/0525; H01M 10/48;
H01M 2220/20; Y02E 60/10

(54) **BATTERY DETERIORATION-CALCULATION METHOD AND APPARATUS**

BATTERIE-ALTERUNGS-BERECHNUNGSVERFAHREN UND VORRICHTUNG

PROCÉDÉ DE CALCUL DE VIEILLISSEMENT D'UNE BATTERIE ET APPAREIL DE CALCUL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.05.2011   JP 2011122965**

(43) Date of publication of application:
**05.12.2012   Bulletin 2012/49**

(73) Proprietor: **Kabushiki Kaisha Toshiba
Minato-ku,
Tokyo 105-8001 (JP)**

(72) Inventors:
• **Hoshino, Masayuki
Tokyo, Tokyo 105-8001 (JP)**
• **Morita, Tomokazu
Tokyo, Tokyo 105-8001 (JP)**

(74) Representative: **AWA Sweden AB
P.O. Box 11394
404 28 Göteborg (SE)**

(56) References cited:
**JP-A- 2003 308 885       US-A1- 2010 121 591
US-A1- 2010 156 351     US-A1- 2011 012 604**

**Description**

**CROSS-REFERENCE TO RELATED APPLICATIONS**

This application is based upon and claims the benefit of priority from the prior Japanese Patent Application No. 2011-122965, filed on May 31, 2011,

**FIELD**

Embodiments described herein generally relate to a calculation method, a calculation system, and a calculation apparatus that calculate a deterioration state of a battery.

**BACKGROUND**

Studies of a calculation method, a calculation system, and a calculation apparatus that calculate a deterioration state of a battery are progressing. For example, as disclosed in Japanese Patent Application Laid-open No. 2011-75461, an evaluation of a battery cell with use of a value of a capacity of the battery cell is performed.

However, the evaluation based only on the capacity fails to grasp a more precise status, for example, because which one of a cathode and an anode is deteriorated.

A method and an apparatus for estimating a state of charge of a battery are disclosed in US 2010/121591 A1.

**BRIEF DESCRIPTION OF THE DRAWINGS**

Fig. 1 is a block diagram of a calculation system according to a first embodiment;
Fig. 2 is a block diagram of a battery apparatus according to the first embodiment;
Fig. 3 is a graph showing an example of an electromotive force with respect to a charge amount of a cathode using an active material A and an active material B;
Fig. 4 is a graph showing an example of a potential with respect to the charge amount of the cathode;
Fig. 5 is a graph showing an example of a change in potential with respect to a charge amount of an anode due to an increase of a current value.
Fig. 6 is a graph showing an example of a detection value of a charging voltage with respect to a charging time;
Fig. 7 is a flowchart showing an operation of a calculation apparatus according to the first embodiment;
Fig. 8 is a flowchart showing an example of a regression calculation according to the first embodiment;
Fig. 9 is a flowchart showing an example of a charge amount distribution calculation according to the first embodiment;
Fig. 10 is a diagram showing a modification of the calculation apparatus according to the first embodiment;
Fig. 11 is a block diagram showing an operation of the calculation apparatus according to the first embodiment;
Fig. 12 is a block diagram showing an operation of the calculation apparatus according to the first embodiment;
Fig. 13 is a block diagram showing an operation of the calculation apparatus according to the first embodiment; and
Fig. 14 is a block diagram showing an operation of the calculation apparatus according to the first embodiment.

**DETAILED DESCRIPTION**

In view of the above circumstances, an aspect of embodiments provides a calculation method of implementing a computation capability of: referring to a detection value database configured to store a charge amount of a battery and a voltage of the battery, the voltage being generated when the battery is charged, while associating the charge amount of the battery with the voltage of the battery, and a function information database configured to store a function representing a relationship between the voltage and a charge amount of each of a plurality of active materials included in the battery; and performing a regression calculation on the voltage of the battery that is stored in the detection value database, with an amount of the active materials of the function stored in the function information database being set as a variable.

According to the aspect of embodiments, a deterioration state of a battery is calculated more precisely.

Hereinafter, the embodiment will be described with reference to the drawings.

(First Embodiment)

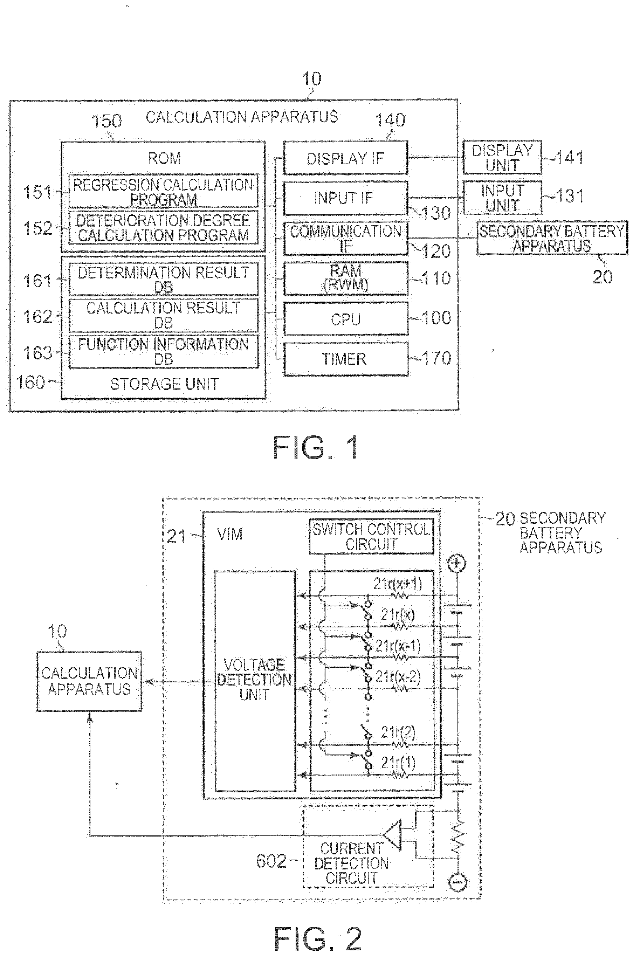

Fig. 1 is a configuration diagram of a calculation system according to this embodiment.

The calculation system shown in Fig. 1 is a computer system that calculates a remaining capacity of a secondary battery apparatus 20. In this embodiment, a calculation apparatus 10 as one of constituent elements of the calculation system is constituted of a calculation apparatus group in which apparatuses are used in combination via communication networks such as a LAN (local area network) and an intranet in accordance with processing performance of the apparatuses.

The calculation apparatus 10 includes a CPU (central processing unit) 100, a RAM (random access memory) or a RWM (read-write memory) 110, a communication IF (interface) 120, an input IF 130, a display IF 140, a ROM (read-only memory) 150, a storage unit 160, and a timer 170. In addition, the calculation apparatus 10 may include an interface for mounting thereto an external storage device such as a USB (universal serial bus) memory. The calculation apparatus 10 is a computer that executes programs and performs a computation.

The calculation apparatus 10 collects data including a current value, a voltage value, and the like from the secondary battery apparatus 20 via the communication IF 120 and uses the collected data to perform various types of computation processing.

The CPU 100 is a computation processing unit (microprocessor) that reads out, to the RAM 110, programs written in advance into the ROM 150 and performs calculation processing. The CPU 100 is constituted of a plurality of CPU groups (microcomputers and microcontrollers) in accordance with capabilities. Further, the CPU may include a built-in memory having a RAM capability.

The RAM (RWM) 110 is a memory that serves as a storage area used by the CPU 100 when executing programs and is used as a working area. The RAM (RWM) 110 is suitably used for primary storage of data necessary for processing.

The communication IF 120 is a communication apparatus or a communication unit that exchanges data with the second battery apparatus 20. Examples of the communication IF 120 include a router. In this embodiment, the connection between the communication IF 120 and the secondary battery apparatus 20 is described as being established by wired communication, but the connection may be established by various wireless communication networks, instead of the wired communication. Further, the connection between the communication IF 120 and the secondary battery apparatus 20 may have a form to be established via a network that allows one-way or two-way communication.

The input IF 130 is an interface that connects an input unit 131 and the calculation apparatus 10 to each other. The input IF 130 may have an input control capability of converting an input signal transmitted from the input unit 131 into a signal that is recognizable by the CPU 100. This interface is not an indispensable constituent element as a terminal or the like and may be directly connected to wiring within the calculation apparatus 10.

The input unit 131 is an input apparatus or an input unit that controls inputs received from various types of keyboards, buttons, and the like that are generally provided to a computer apparatus. In addition, the input unit 131 may have a capability of recognizing a human voice to thereby recognize or detect the voice as an input signal. In this embodiment, the input unit 131 is externally provided to the calculation apparatus 10, but the input unit 131 may have a form to be incorporated into the calculation apparatus 10.

The display IF 140 is an interface that connects a display unit 141 and the calculation apparatus 10 to each other. Display control on the display unit 141 may be performed by the CPU 100 via the display IF 140 or may be performed by an LSI (large-scale integration) or a GPU (graphics processing unit) for performing drawing processing, such as a graphics board. The display control capability includes, for example, a decoding capability of decoding image data. The display IF 140 may have a form to be directly connected to the inside of the calculation apparatus 10 without using interfaces.

The display unit 141 is an output apparatus or an output unit such as a liquid crystal display, an organic EL (electroluminescence) display, or a plasma display. Additionally, the display unit 141 may have a capability of emitting a sound. In this embodiment, the display unit 141 is externally provided to the calculation apparatus 10, but the display unit 141 may be incorporated into the calculation apparatus 10.

The ROM 150 is a program memory that stores a regression calculation program 151 and a deterioration degree calculation program 152. Here, a non-primary storage medium into which data is not written is suitably used therefor, but the ROM 150 may be a storage medium such as a semiconductor memory capable of reading and writing data as needed. In addition, the ROM 150 may store a display program causing image data to be displayed, as a letter or a pattern that is recognizable by a human, on the display unit 141, a program causing content such as battery deterioration information to be distributed to a terminal 30 via the communication IF 120, an information register program causing acquired data to be stored in the storage unit 160 at predetermined time intervals, and other programs.

The regression calculation program 151 is a unit that causes the CPU 100 to implement a capability of calculating an internal resistance value and capacity values of a cathode and an anode for each of battery cells or assembled batteries that constitute the secondary battery apparatus 20. For example, the following seven values are calculated (analyzed): (1) a capacity of an active material A constituting a cathode; (2) a capacity of an active material B constituting the cathode; (3) a capacity of an anode; (4) a charge amount of the active material A constituting the cathode; (5) a charge amount of the active material B constituting the cathode; (6) a charge amount of the anode; and (7) an internal resistance value.

$$Q_{cA}、\ Q_{cB}、\ Q_a、\ q_0^{cA}、\ q_0^{cB}、\ q_0^a、\ R$$

(Numerical Value 1)

Using those values, a change characteristic of a charging voltage to a time, and a characteristic of a cathode potential to the charge amount and/or that of an anode potential to the charge amount are calculated. A specific operation will be described later.

The regression calculation program 151 is constituted of program groups corresponding to respective expressions below. Note that the order of programs is variously changed.

A charging voltage $V_c$ is obtained from Expression 2 below, using an electromotive voltage $V_e$ of the battery and a voltage $V_R$ based on the internal resistance of the battery.

$$V_C = V_e + V_R \qquad \text{(Expression 2)}$$

The electromotive voltage $V_e$ of the battery is obtained from Expression 3 below, using a potential $E_c$ of the cathode and a potential $E_a$ of the anode.

$$V_e = E_c - E_a \qquad \text{(Expression 3)}$$

The potential of the cathode and that of the anode are obtained from Expression 4 and Expression 5 below, using a charge amount (q), a capacity $Q_{ic}$ of the cathode in an initial state, and a capacity $Q_{ia}$ of the anode in the initial state.

$$E_c = f_c(q/Q_{ic}) \qquad \text{(Expression 4)}$$

$$E_a = f_a(q/Q_{ia}) \qquad \text{(Expression 5)}$$

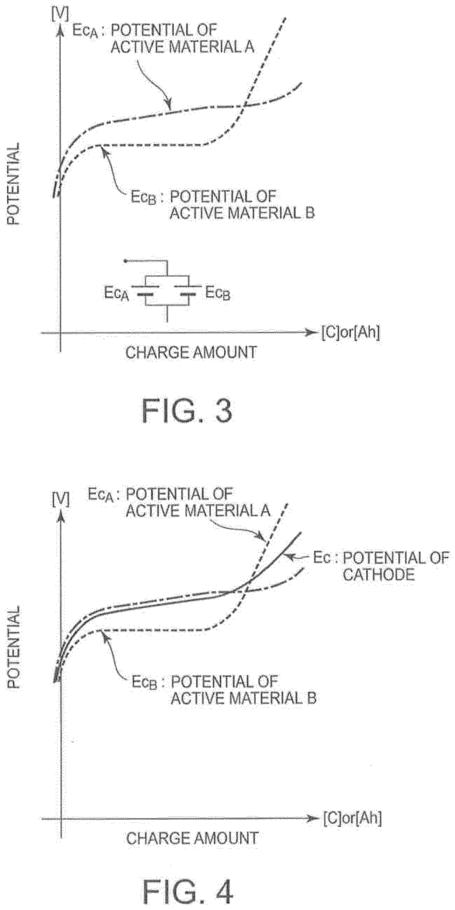

Here, a description will be given of a case where the cathode or the anode is formed of a plurality of active materials. In this case, as shown in Fig. 3, the electromotive forces of the respective active materials show different characteristics. The active material A (for example, lithium manganate) and the active material B (for example, cobalt manganate) are mixed to obtain a complex cathode, and characteristics of an electromotive voltage of the complex cathode with respect to the charge amount are calculated. The calculated characteristics are as shown in Fig. 4.

A potential $E_{cA}$ of the cathode of the active material A and a potential $E_{cB}$ of the cathode of the active material B have relationships shown in Expressions 6, 7, 8, and 9 below (Fig. 3), using a capacity $Q_{icA}$ of the active material A in the initial state, a capacity $Q_{icB}$ of the active material B in the initial state, a charge amount $q_A$ of the active material A, and a charge amount $q_B$ of the active material B.

$$E_{cA} = f_{cA}(q_A/Q_{icA}) \qquad \text{(Expression 6)}$$

$$E_{cB} = f_{cB}(q_B/Q_{icB}) \qquad \text{(Expression 7)}$$

$$f_{cA}(q_A/Q_{cA}) = f_{cB}(q_B/Q_{cB}) \qquad \text{(Expression 8)}$$

$$q = q_A + q_B \qquad \text{(Expression 9)}$$

Therefore, a potential $E_c$ of the complex cathode is obtained from Expression 10 below, using a capacity $q_A$ of the cathode of the active material A at a start of charging and a charge amount $Q_{cA}$ of the cathode of the active material A or using a capacity $q_B$ of the cathode of the active material B at a start of charging and a charge amount $Q_{cB}$ of the cathode of the active material B.

$$E_c = f_c(q/Q_{ic}) = f_{cA}(q_A/Q_{cA}) = f_{cB}(q_B/Q_{cB}) \qquad \text{(Expression 10)}$$

Note that the potential $E_{cA}$ of the cathode of the active material A and the potential $E_{cB}$ of the cathode of the active material B are each a potential of a surface of each active material. Therefore, since the diffusion resistance of a lithium ion within the active material changes a distribution of a lithium ion within the active material, a relationship between the charge amount and the electromotive voltage seems to be changed due to a charging current. In this embodiment, however, since an active material used for the cathode and a carbon-based active material used for the anode each have a small diffusion resistance therewithin, the active materials are handled as materials for which the relationship between the charging current and the electromotive voltage is not largely changed even if the charging current varies.

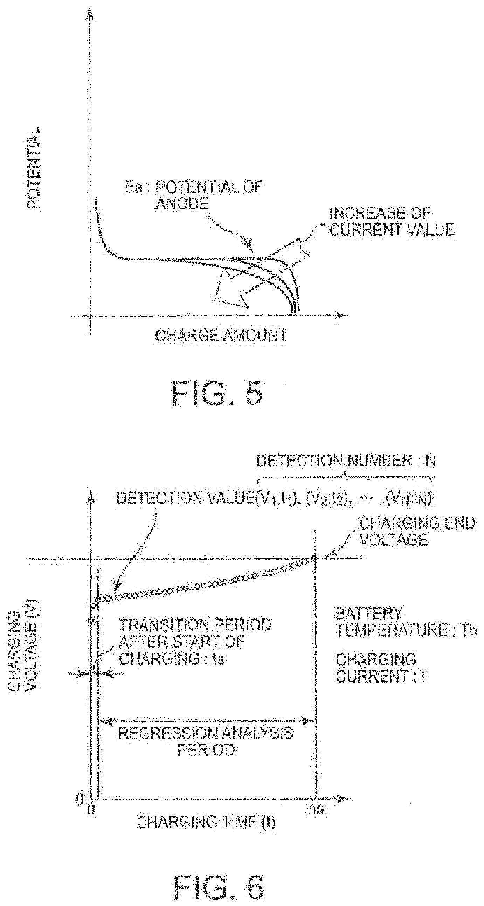

On the other hand, in the case where a material having a large diffusion resistance, such as lithium titanate, is used as an active material of the anode, as shown in Fig. 5, the relationship between the charge amount and the electromotive voltage is largely changed due to the current value, and therefore the approximation similar to that for the cathode is not performed.

Accordingly, the potential $E_a$ of the anode is represented by Expression 11.

$$E_a = f_a(q/Q_{ia}, I/Q_{ia}) \qquad \text{(Expression 11)}$$

Further, the voltage $V_R$ based on the internal resistance is obtained from Expressions 12 and 13, using a charging current I and the internal resistance R(q).

$$V_R = R(q) \times I \qquad \text{(Expression 12)}$$

$$q = \int I dt \qquad \text{(Expression 13)}$$

Specifically, Expression 2 is represented as the following expression.

$$V_c = f_c(q/Q_{ic}) - f_a(q/Q_{ia}, I/Q_{ia}) + R(q) \times I \qquad \text{(Expression 2A)}$$

As described above, a non-linear correlation is found among the charging voltage, the electromotive voltage characteristics of the active material, and the internal resistance. Based on the above, with the internal resistance and the capacity of the active material being set as variables, a regression calculation is performed on a characteristic curve of the charging voltage with respect to the charge amount to thereby calculate and determine an internal resistance and a capacity of the active material.

The deterioration degree calculation program 152 is a unit that causes the CPU 100 to implement a capability of calculating a degree of deterioration of the secondary battery apparatus 20 from the values of the internal resistance and the capacity of the active material, the values being obtained by executing the regression calculation program 151.

After the internal resistance and the capacity of each of the active materials are set to be variables and a function for obtaining the degree of deterioration is stored in a function information DB (database) 163, a function is read out from the function information DB 163 to be compared with the internal resistance and the capacity of each of the active materials that are obtained by the regression calculation program 151, to thereby calculate a degree of deterioration of the secondary battery apparatus 20.

For example, after a reference value of the capacity and that of the internal resistance are stored, in the case where a value of the capacity or internal resistance obtained by the regression calculation program 151 becomes smaller than the reference value, it may be determined that the secondary battery apparatus 20 is too deteriorated to be used. Alternatively, depending on use applications, after a computation method (function) for a deterioration index to be computed based on the capacity value and the internal resistance value is stored, the deterioration index computed using the internal resistance value and the capacity value obtained by the regression calculation program 151 may be presented as a degree of deterioration.

The storage unit 160 is a nonvolatile storage device or storage unit such as a hard disk drive (HDD). The storage unit 160 is not limited to the nonvolatile storage unit. A semiconductor memory such as a flash memory may be used therefor or a storage medium in a form in which those semiconductor memories and the HDD are combined may be used therefor. In this embodiment, the ROM 150 and the storage unit 160 are described as different storage media.

However, the ROM and the storage unit may be combined to each other as one storage unit.

The storage unit 160 stores a determination result DB 161, a calculation result DB 162, and the function information DB 163. In addition, the storage unit 160 also stores data necessary for calculation processing performed by the CPU 100 therein.

The determination result DB 161 stores determination data including the determined current value, voltage value, and the like of the secondary battery apparatus 20 at predetermined determination intervals. For example, the data is stored in a form of a table. The data is drawn as shown in Fig. 6. The stored data on the determination result is used when the regression calculation program 151 is executed.

The calculation result DB 162 stores a value calculated by the CPU 100 executing the regression calculation program 151. The stored value may be read out by the CPU 100 and displayed on the display unit 141 via the display IF 140. Instead of this storage unit, the data described above may be stored on a storage medium provided externally to the calculation apparatus 10 in a cloud computing system.

Further, the function information DB 163 stores a function representing a relationship between the cathode potential and the charge amount as shown in Fig. 4, a function representing a relationship between the anode potential and the charge amount as shown in Fig. 5, and values thereof. Those functions and values mean that the relationship between the anode potential and the charge amount shown in Fig. 5 reduces, due to an increase of the current value, a region where the anode potential with respect to the charge amount becomes constant. This function information is used when the degree of deterioration of the cathode and that of the anode are evaluated.

Further, data used when a potential of the cathode with respect to the charge amount and that of the anode with respect to the charge amount are obtained are also stored. In the case where the cathode or the anode is formed of a plurality of materials, a function corresponding to each of the materials is stored.

The timer 170 is a clock for counting a time. Using the counted time of day, the CPU 100 detects and stores the current value and the voltage value. The calculation apparatus 10 may have a form to acquire a time via a network instead of the timer 170, or may have a form to calculate a time of day based on the count of the timer 170 and the time of day that is acquired from the network.

The secondary battery apparatus 20 is an apparatus including a battery and a control circuit that detects a current value, a voltage value, and the like of the battery. For the battery, various secondary batteries may be used. For example, a VTM (voltage transformation module) 21 detects a voltage, and a current detection circuit 602 detects a current.

The terminal 30 is a vehicle that loads the above-mentioned secondary battery apparatus 20 or a stationary battery apparatus. The terminal 30 includes a CPU 300, a RAM (RWM) 310, a communication IF 320, an input IF 331, a display IF 341, a ROM 350, a storage unit 360, a timer 370, and a rechargeable battery 380. Note that the terminal 30 may include a charger 381 that charges the rechargeable battery, and an inverter 382 that performs DC-AC conversion at a time when power is transmitted to a motor 383 from the rechargeable battery. Alternatively, instead of the CPU 300 that controls the terminal 30, a programable controller 385 may be used.

The capabilities of the respective constituent elements of the terminal 30 are the same as those of the constituent elements of the calculation apparatus 10, and therefore a description thereof will be omitted. Note that the CPU 100 and the CPU 300 may divide the programs for execution. The rechargeable battery 380 is a secondary battery apparatus 20.

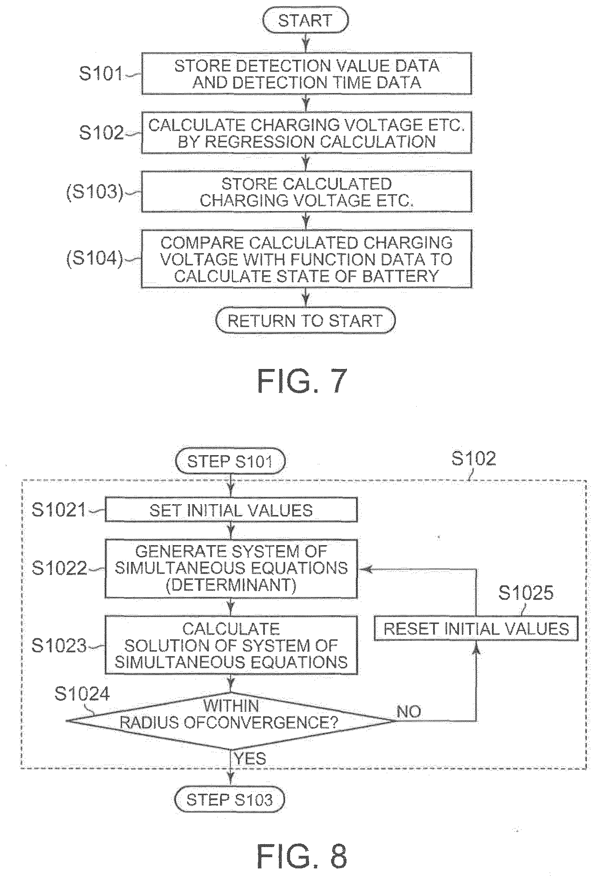

Next, an example of a specific operation will be described mainly with reference to Figs. 7 and 8.

A charging current value in the case of constant current charging is described for simplicity. The charging current value is not necessarily constant, but it is suitable to be detected in the constant current charging, because of less occurrence of detection errors and calculation errors.

Further, the internal resistance value is handled as a value that does not vary with respect to the charge amount q.

Further, in this embodiment, a description will be given of a case where a voltage is detected for each battery cell. In the case where the calculation method of this embodiment is used for a battery module including a plurality of cells, like an assembled battery, since a progress status of deterioration differs between the cells, it is suitable to detect a time variation of the charging voltage for each of the cells (Step S101).

The charging voltage thus detected is stored in the determination result DB 161. During a charging time $t_c$ from a start of charging to a time when a charging end voltage is obtained, N detection values are obtained. Since the charging voltage is not stable immediately after the start of charging, that is, during a transition period, ns pieces of data obtained during this transition period ts are not used in the regression calculation for calculating an internal resistance and a capacity of an active material.

The calculation apparatus 10 acquires a detection value of a charging voltage in each cell. The acquired value is temporarily stored in the RAM 110 or stored in the storage unit 160.

The CPU 100 executes the regression calculation program 151 read from the ROM 150 and analyzes a solution of a non-linear differential equation by the regression calculation (Step S102).

Since the constant current charging is performed, a charge amount $q_c$ from the start of charging is obtained from Expression 13 below.

$$q_c = I * t$$

In such a manner, detection voltages corresponding to the charge amount q, that is, detection values $(V_{-}, q_{c1})$, $(V_2, q_{c2})$, ........., $(V_N, q_{cN})$ are obtained.

The CPU 100 causes the RAM 110 to temporarily store the obtained values therein or the storage unit 160 to store them therein.

Using the above-mentioned detection values, the regression calculation is performed. A residual sum of squares to be used when the regression calculation is performed is represented by the following expression.

$$S = \sum_{n=ns+1}^{N} \left( V_n - \left( f_c \left( (q_{cn} + q_0^c) / Qc \right) - f_a \left( (q_{cn} + q_0^a) / Qa, I / Qa \right) \right) \right)^2$$

$q_0^c$ : Amount of charge in cathode at start of charging

$q_0^a$ : Amount of charge in anode at start of charging

(Expression 14)

The charge amount at the start of charging is an unknown when the regression calculation is performed, which means that the charge amount of the cathode and that of the anode at the start of charging are also unknowns.

In this embodiment, in the case where the cathode is a complex cathode formed of the active material A and the active material B, unknowns of the regression calculation are the following values.

$$Q_{cA}, \quad Q_{cB}, \quad Q_a, \quad q_0^{cA}, \quad q_0^{cB}, \quad q_0^a, \quad R$$

(Numerical Value 15)

Accordingly, a solution of the following system of simultaneous equations is obtained (Step S1022).

$$\begin{cases} \partial S / \partial Q_{cA} = 0 \\ \partial S / \partial Q_{cB} = 0 \\ \partial S / \partial Q_{a} = 0 \\ \partial S / \partial q_0^{cA} = 0 \\ \partial S / \partial q_0^{cB} = 0 \\ \partial S / \partial q_0^{a} = 0 \\ \partial S / \partial R = 0 \end{cases}$$

(Expression 16)

As initial values, appropriate values, e.g., values of the last determination are used (Step S1021).

$$\begin{cases} \partial S / \partial Q_{cA} = 0 \\ \partial S / \partial Q_{cB} = 0 \\ \partial S / \partial Q_{a} = 0 \\ \partial S / \partial q_0^{cA} = 0 \\ \partial S / \partial q_0^{cB} = 0 \\ \partial S / \partial q_0^{a} = 0 \\ \partial S / \partial R = 0 \end{cases}$$

(Expression 17)

Values for the subsequent step are obtained by the following expression (Step S1023).

$$\begin{cases} Q_{cA} \leftarrow Q_{cA} + \delta Q_{cA} \\[4pt] Q_{cB} \leftarrow Q_{cB} + \delta Q_{cB} \\[4pt] Q_a \leftarrow Q_a + \delta Q_a \\[4pt] q_0^{cA} \leftarrow q_0^{cA} + \delta q_0^{cA} \\[4pt] q_0^{cB} \leftarrow q_0^{cB} + \delta q_0^{cB} \\[4pt] q_0^{a} \leftarrow q_0^{a} + \delta q_0^{a} \\[4pt] R \leftarrow R + \delta R \end{cases}$$

(Expression 18)

In this case, the following values are obtained by solving the next expression.

$$\delta Q_{cA}, \quad \delta Q_{cB}, \quad \gamma Q_a, \quad \delta q_0^{cA}, \quad \delta q_0^{cB}, \quad \delta R$$

(Numerical Value 19)

In this embodiment, the description is given using Newton's method. Instead thereof, however, another numerical analytical approach such as a Levenberg-Marquardt algorithm may be used.

$$
\begin{pmatrix}
\dfrac{\partial^2 S}{\partial Q_{cA}^2} & \dfrac{\partial^2 S}{\partial Q_{cA}\partial Q_{cB}} & \dfrac{\partial^2 S}{\partial Q_{cA}\partial Q_a} & \dfrac{\partial^2 S}{\partial Q_{cA}\partial q_0^{cA}} & \dfrac{\partial^2 S}{\partial Q_{cA}\partial q_0^{cB}} & \dfrac{\partial^2 S}{\partial Q_{cA}\partial q_0^{a}} & \dfrac{\partial^2 S}{\partial Q_{cA}\partial R} \\[2mm]
\dfrac{\partial^2 S}{\partial Q_{cA}\partial Q_{cB}} & \dfrac{\partial^2 S}{\partial Q_{cB}^2} & \dfrac{\partial^2 S}{\partial Q_{cB}\partial Q_a} & \dfrac{\partial^2 S}{\partial Q_{cB}\partial q_0^{cA}} & \dfrac{\partial^2 S}{\partial Q_{cB}\partial q_0^{cB}} & \dfrac{\partial^2 S}{\partial Q_{cB}\partial q_0^{a}} & \dfrac{\partial^2 S}{\partial Q_{cB}\partial R} \\[2mm]
\dfrac{\partial^2 S}{\partial Q_{cA}\partial Q_a} & \dfrac{\partial^2 S}{\partial Q_{cB}\partial Q_a} & \dfrac{\partial^2 S}{\partial Q_a^2} & \dfrac{\partial^2 S}{\partial Q_a\partial q_0^{cA}} & \dfrac{\partial^2 S}{\partial Q_a\partial q_0^{cB}} & \dfrac{\partial^2 S}{\partial Q_a\partial q_0^{a}} & \dfrac{\partial^2 S}{\partial Q_a\partial R} \\[2mm]
\dfrac{\partial^2 S}{\partial Q_{cA}\partial q_0^{cA}} & \dfrac{\partial^2 S}{\partial Q_{cB}\partial q_0^{cA}} & \dfrac{\partial^2 S}{\partial Q_a\partial q_0^{cA}} & \dfrac{\partial^2 S}{\partial q_0^{cA^2}} & \dfrac{\partial^2 S}{\partial q_0^{cA}\partial q_0^{cB}} & \dfrac{\partial^2 S}{\partial q_0^{cA}\partial q_0^{a}} & \dfrac{\partial^2 S}{\partial q_0^{cA}\partial R} \\[2mm]
\dfrac{\partial^2 S}{\partial Q_{cA}\partial q_0^{cB}} & \dfrac{\partial^2 S}{\partial Q_{cB}\partial q_0^{cB}} & \dfrac{\partial^2 S}{\partial Q_a\partial q_0^{cB}} & \dfrac{\partial^2 S}{\partial q_0^{cA}\partial q_0^{cB}} & \dfrac{\partial^2 S}{\partial q_0^{cB^2}} & \dfrac{\partial^2 S}{\partial q_0^{cB}\partial q_0^{a}} & \dfrac{\partial^2 S}{\partial q_0^{cB}\partial R} \\[2mm]
\dfrac{\partial^2 S}{\partial Q_{cA}\partial q_0^{a}} & \dfrac{\partial^2 S}{\partial Q_{cB}\partial q_0^{a}} & \dfrac{\partial^2 S}{\partial Q_a\partial q_0^{a}} & \dfrac{\partial^2 S}{\partial q_0^{cA}\partial q_0^{a}} & \dfrac{\partial^2 S}{\partial q_0^{cB}\partial q_0^{a}} & \dfrac{\partial^2 S}{\partial q_0^{a^2}} & \dfrac{\partial^2 S}{\partial q_0^{a}\partial R} \\[2mm]
\dfrac{\partial^2 S}{\partial Q_{cA}\partial R} & \dfrac{\partial^2 S}{\partial Q_{cB}\partial q_0^{a}} & \dfrac{\partial^2 S}{\partial Q_a\partial R} & \dfrac{\partial^2 S}{\partial q_0^{cA}\partial R} & \dfrac{\partial^2 S}{\partial q_0^{cB}\partial R} & \dfrac{\partial^2 S}{\partial q_0^{a}\partial R} & \dfrac{\partial^2 S}{\partial R^2}
\end{pmatrix}
\begin{pmatrix}
\delta Q_{cA} \\[2mm] \delta Q_{cB} \\[2mm] \delta Q_a \\[2mm] \delta q_0^{cA} \\[2mm] \delta q_0^{cB} \\[2mm] \delta q_0^{a} \\[2mm] \delta R
\end{pmatrix}
=
\begin{pmatrix}
-\dfrac{\partial S}{\partial Q_{cA}} \\[2mm]
-\dfrac{\partial S}{\partial Q_{cB}} \\[2mm]
-\dfrac{\partial S}{\partial Q_{ca}} \\[2mm]
-\dfrac{\partial S}{\partial q_0^{cA}} \\[2mm]
-\dfrac{\partial S}{\partial q_0^{cB}} \\[2mm]
-\dfrac{\partial S}{\partial q_0^{a}} \\[2mm]
-\dfrac{\partial S}{\partial R}
\end{pmatrix}
$$

(Expression 20)

The computation is repeated until the obtained values satisfy the following convergence condition (radius of convergence) (Steps S1024 and S1025).

$$
\begin{cases}
\delta Q_{cA} < \varepsilon_{Q_{cA}} \\[2mm]
\delta Q_{cB} < \varepsilon_{Q_{cB}} \\[2mm]
\delta Q_a < \varepsilon_{Q_A} \\[2mm]
\delta q_0^{cA} < \varepsilon_{q_0^{cA}} \\[2mm]
\delta q_0^{cB} < \varepsilon_{q_0^{cB}} \\[2mm]
\delta q_0^{a} < \varepsilon_{q_0^{a}} \\[2mm]
\delta R < \varepsilon_R
\end{cases}
$$

(Expression 21)

Results of the computations repeated in such a manner are stored in the storage unit 160 (Step S103).

Next, the CPU 100 executes the deterioration degree calculation program 152.

The capacity and the internal resistance that have been calculated by the regression calculation program 151 described above are compared with deterioration references stored in advance, or a computation method (function) stored in advance is performed using those capacity and internal resistance, to thereby calculate a degree of deterioration (Step S104).

The CPU 100 executes a display control method such as a display program to display the calculated results on the display unit 141.

Note that the charging voltage and the internal resistance that have been computed in Step S102 may be displayed on the display unit 141 as they are.

Next, computation processing in Step S1022 will be exemplified.

First of all, in the case where the cathode or the anode is a single electrode, when a calculation is performed for the third column and the third row in Expression 27, for example, the following expression is obtained.

$$\frac{\partial^2 S}{\partial Q_a^{\ 2}} = \frac{\partial^2}{\partial Q_a^{\ 2}} \sum_{n=ns+1}^{N} \left( V_n - \left( f_c \left( (q_{cn} + q_0^c)/Q_c \right) - f_a \left( (q_{cn} + q_0^a)/Q_a, I/Q_a \right) \right) - R \times I \right)^2$$

$$= \sum_{n=ns+1}^{N} \frac{\partial^2}{\partial Q_a^{\ 2}} \left( V_n - \left( f_c \left( (q_{cn} + q_0^c)/Q_c \right) - f_a \left( (q_{cn} + q_0^a)/Q_a, I/Q_a \right) \right) - R \times I \right)^2$$

(Expression 22)

Then, a differentiation is performed using a small displacement $\Delta Qc$, and the following expression is obtained.

$$\sum_{n=ns+1}^{N} \frac{\partial^2}{\partial Q_a} \left( V_n - \left( f_c \left( (q_{cn} + q_0^c)/Q_c \right) - f_a \left( (q_{cn} + q_0^a)/Q_a, I/Q_a \right) \right) - R \times I \right)^2$$

$$= \sum_{n=ns+1}^{N} \left( \frac{\left( V_n - \left( f_c \left( (q_{cn} + q_0^c)/Q_c \right) - f_a \left( (q_{cn} + q_0^a)/(Q_a + \delta Q_a), I/(Q_a + \delta Q_a) \right) \right) - R \times I \right)^2}{\delta Q_a^{\ 2}} \right.$$

$$- 2 \frac{\left( V_n - \left( f_c \left( (q_{cn} + q_0^c)/Q_c \right) - f_a \left( (q_{cn} + q_0^a)/(Q_a), I/(Q_a) \right) \right) - R \times I \right)^2}{\delta Q_a^{\ 2}}$$

$$\left. \frac{\left( V_n - \left( f_c \left( (q_{cn} + q_0^c)/Q_c \right) - f_a \left( (q_{cn} + q_0^a)/(Q_a - \delta Q_a), I/(Q_a - \delta Q_a) \right) \right) - R \times I \right)^2}{\delta Q_a^{\ 2}} \right)$$

(Expression 23)

In the same manner, when a calculation is performed for the first row and the seventh column in Expression 27, the following expression is obtained.

$$\sum_{n=ns+1}^{N} \frac{\partial^2}{\partial Q_a \partial R} \left( V_n - \left( f_c \left( (q_{cn} + q_0^c)/Q_c \right) - f_a \left( (q_{cn} + q_0^a)/Q_a, I/Q_a \right) \right) - R \times I \right)^2$$

$$= \sum_{n=ns+1}^{N} \left( \frac{\left( V_n - \left( f_c \left( (q_{cn} + q_0^c)/Q_c \right) - f_a \left( (q_{cn} + q_0^a)/(Q_a + \delta Q_a), I/(Q_a + \delta Q_a) \right) \right) - (R + \delta R) \times I \right)^2}{4 \delta Q_a \delta R} \right.$$

$$- \left( \frac{\left( V_n - \left( f_c \left( (q_{cn} + q_0^c)/Q_c \right) - f_a \left( (q_{cn} + q_0^a)/(Q_a + \delta Q_a), I/(Q_a + \delta Q_a) \right) \right) - (R - \delta R) \times I \right)^2}{4 \delta Q_a \delta R} \right)$$

$$- \left( \frac{\left( V_n - \left( f_c \left( (q_{cn} + q_0^c)/Q_c \right) - f_a \left( (q_{cn} + q_0^a)/(Q_a - \delta Q_a), I/(Q_a - \delta Q_a) \right) \right) - (R + \delta R) \times I \right)^2}{4 \delta Q_a \delta R} \right)$$

$$\left. \frac{\left( V_n - \left( f_c \left( (q_{cn} + q_0^c)/Q_c \right) - f_a \left( (q_{cn} + q_0^a)/(Q_a - \delta Q_a), I/(Q_a - \delta Q_a) \right) \right) - (R - \delta R) \times I \right)^2}{4 \delta Q_a \delta R} \right)$$

(Expression 24)

A calculation is similarly performed for other terms.

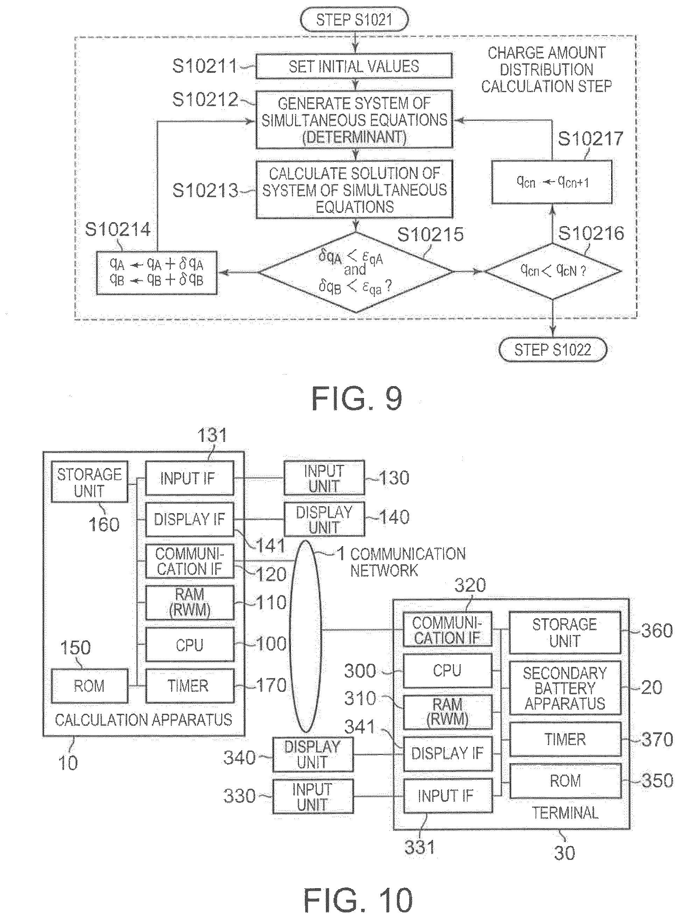

Next, a description will be given of preprocessing for a computation in Step S1022 in the case where the cathode is formed of a complex material, with reference to Fig. 9.

First of all, initial values are set (Step S10211). [0083] $q_{cn} \leftarrow q_{c\,ns+1}$, $q_A$), $q_B$

Next, a system of simultaneous equations for $q_A$ and $q_B$ is generated, and a solution is obtained (Steps S10212 and S10213) .

$$\frac{\partial f_{cA}\left(q_{An}/Q_{cA}\right)}{\partial q}\delta q_A - \frac{\partial f_{cB}\left(q_{Bn}/Q_{cB}\right)}{\partial q}\delta q_B = -f_{cA}\left(q_{An}/Q_{cA}\right) + f_{cB}\left(q_{Bn}/Q_{cB}\right)$$

$$[A_c] = \begin{pmatrix} \dfrac{\partial f_{cA}\left(\left(q_{An}+q_0^{cA}\right)/Q_{cA}\right)}{\partial q} & \dfrac{\partial f_{cB}\left(\left(q_{Bn}+q_0^{cB}\right)/Q_{cB}\right)}{\partial q} \\ 1 & 1 \end{pmatrix}$$

$$(B_c) = \begin{pmatrix} -f_{cA}\left(\left(q_{An}+q_0^{cA}\right)/Q_{cA}\right) + f_{cB}\left(\left(q_{Bn}+q_0^{cB}\right)/Q_{cB}\right) \\ q_{cn} - q_{An} - q_{Bn} \end{pmatrix}$$

(Expression 25)

Then, it is determined whether the solution falls in the predetermined radius of convergence (Step S10214).

$$\delta q_A < \varepsilon_{q_A}$$

$$and$$

$$\delta q_B < \varepsilon_{q_B}$$

(Expression 26)

In the case where the solution does not fall therein, new initial values are set to obtain $q_A$ and $q_B$ (Step S10215).
In the case where the solution falls therein (YES of Step S10214), a calculation for the next detection point is performed (Steps S10216 and S10217).
The obtained solution is represented by the following expression.

$$\begin{pmatrix} q_{c\,ns+1} & q_{A\,ns+1} & q_{B\,ns+1} \\ q_{c\,ns+2} & q_{A\,ns+2} & q_{B\,ns+2} \\ \vdots & \vdots & \vdots \\ q_{c\,N-1} & q_{A\,N-1} & q_{B\,N-1} \\ q_{c\,N} & q_{A\,N} & q_{B\,N} \end{pmatrix}$$

(Expression 27)

Here, a voltage of the cathode is obtained by the following expression.

$$\begin{pmatrix} q_{A\,ns+1} & q_{A\,ns+2} & \cdots & q_{A\,N} \end{pmatrix}$$

(Expression 28)

This sequence is represented as described below.

$$\begin{pmatrix} q_{A\,ns+1}\left(Q_{cA}, Q_{cB}, q_0^{cA}, q_0^{cB}\right) & q_{A\,ns+2}\left(Q_{cA}, Q_{cB}, q_0^{cA}, q_0^{cB}\right) & \cdots & q_{A\,N}\left(Q_{cA}, Q_{cB}, q_0^{cA}, q_0^{cB}\right) \end{pmatrix}$$

(Expression 29)

Then, when a calculation for $\partial^2 S/\partial Q_{cA}$ is exemplified, the following expression is obtained.

$$\sum_{n=ns+1}^{N} \frac{\partial^2}{\partial Q_a} \left( V_n - \left( f_c \left( (q_{cn} + q_0^c) / Q_c \right) - f_a \left( (q_{cn} + q_0^a) / Q_a, I / Q_a \right) \right) - R \times I \right)^2$$

$$= \sum_{n=ns+1}^{N} \left( \frac{\left( V_n - \left( f_{cA} \left( q_{cAn} \left( Q_{cA} + \delta Q_{cA}, Q_{cB}, q_0^{cA}, q_0^{cB} \right) / (Q_{cA} + \delta Q_{cA}) \right) - f_a \left( (q_{cn} + q_0^a) / (Q_a + \delta Q_a), I / (Q_a + \delta Q_a) \right) \right) - R \times I \right)^2}{\delta Q_a^2} \right.$$

$$- 2 \frac{\left( V_n - \left( f_{cA} \left( q_{cAn} \left( Q_{cA}, Q_{cB}, q_0^{cA}, q_0^{cB} \right) / (Q_{cA}) \right) - f_a \left( (q_{cn} + q_0^a) / (Q_a), I / (Q_a) \right) \right) - R \times I \right)^2}{\delta Q_a^2}$$

$$\left. \frac{\left( V_n - \left( f_{cA} \left( q_{cAn} \left( Q_{cA} - \delta Q_{cA}, Q_{cB}, q_0^{cA}, q_0^{cB} \right) / (Q_{cA} - \delta Q_{cA}) \right) - f_a \left( (q_{cn} + q_0^a) / (Q_a - \delta Q_a), I / (Q_a - \delta Q_a) \right) \right) - R \times I \right)^2}{\delta Q_a^2} \right)$$

(Expression 30)

Other terms relating to the cathode are also obtained in the same manner.

As described above, according to this embodiment, the potential of the cathode, the potential of the anode, and the charging voltage are calculated.

As described above, the potential of the cathode and that of the anode are obtained more accurately, which allows a detection of a case where only one of the cathode and the anode is being deteriorated, which would not be allowed in a deterioration determination with use only of a charging voltage. Consequently, a deterioration determination with more accuracy is performed.

In addition, to keep some of the values constant in accordance with the characteristics of the battery achieves processing at high speed.

(Modification)

A description will be given of modifications of the first embodiment with reference to Figs. 10 to 14.

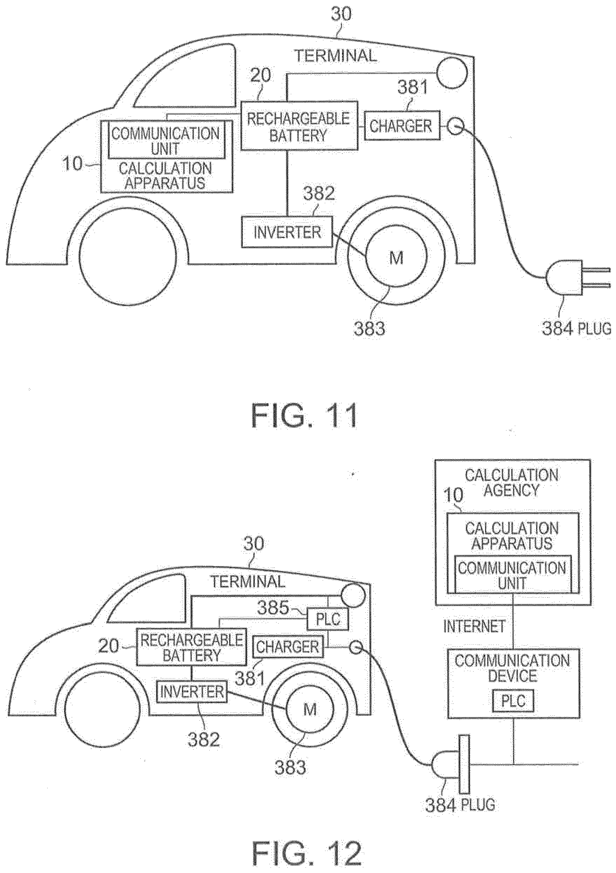

Figs. 10 and 11 show that the terminal 30 includes the calculation apparatus 10. In this case, a server is not necessary to be provided on the upper side, and a reduction in amount of information communication through a communication network 1 is executed.

Fig. 12 shows an embodiment in which a calculation agency collects information of the terminal 30 through the Internet and a communication device to evaluate a state of a battery in the calculation apparatus 10. Data is enabled to be unified for management, which leads to a more precise evaluation for a state of a battery and is additionally useful for maintaining reliability.

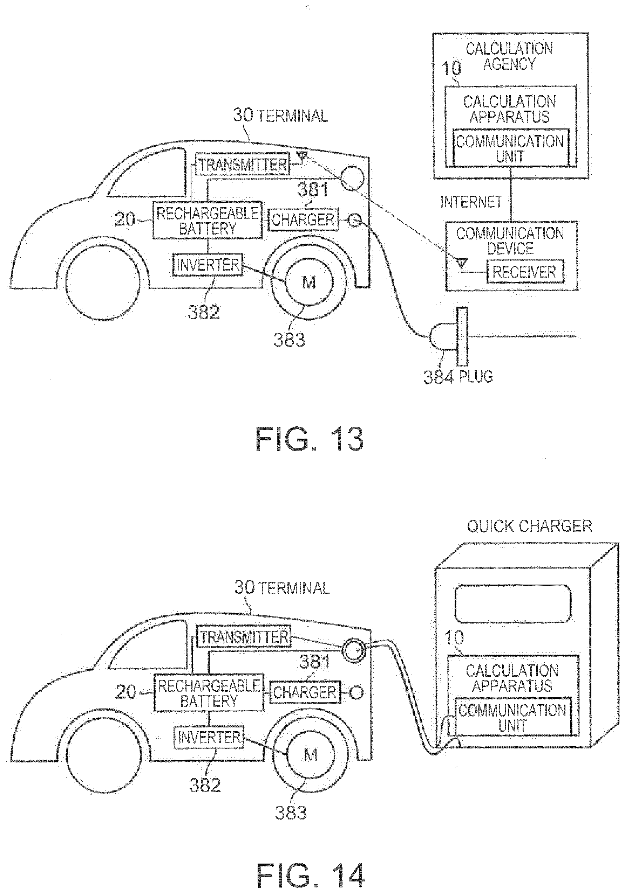

Fig. 13 shows that battery information is collected from the terminal 30 by wireless communication, which is performed at regular time intervals and is suitable to calculate battery characteristics.

Fig. 14 shows an embodiment in which the calculation apparatus 10 is provided in a charger such as a quick charger.

While certain embodiments have been described, these embodiments have been presented by way of example only, and are not intended to limit the scope of the inventions. Indeed, the novel methods and systems described herein may be embodied in a variety of the other forms.

**Claims**

1. A calculation method to calculate a degree of deterioration of a battery, the calculation method being **characterized by** comprising:

   referring to

   a detection value database configured to store a charge amount of a battery and a voltage of the battery, the voltage being generated when the battery is charged, while associating the charge amount of the battery with the voltage of the battery, and
   a function information database (163) configured to store a function representing a relationship between an electrode potential and a charge amount of each of a plurality of active materials included in the battery; and

   determining a degree of deterioration of the battery by performing a regression calculation (S102) on the voltage of the battery that is stored in the detection value database, with capacities of active materials of electrodes, charge amounts of the active materials of the electrodes and an internal resistance value of the function stored in the function information database (163) being set as variables.

2. The calculation method according to claim 1, further comprising calculating a time characteristic of a charging voltage of the battery, with an internal resistance value of the battery and the charge amount of the battery during a period of time from a start of charging to a detection thereof being set as variables, the charge amount being obtained based on a charging current value.

3. The calculation method according to claim 1, further comprising calculating a time characteristic of a charging voltage of the battery, with a change amount of the charge amount of the active materials being set as a variable.

4. The calculation method according to claim 2, wherein the charging current value includes a current value at a time of constant current charging.

5. The calculation method according to claim 1, wherein

   the battery includes at least one of a cathode including the plurality of active materials and an anode including the plurality of active materials,
   the calculation method further comprising

   referring to a function information database (163) configured to store a function representing a relationship between a potential of the plurality of active materials and a charge amount, and
   calculating at least one of a cathode potential of the cathode including the plurality of active materials and an anode potential of the anode including the plurality of active materials.

6. The calculation method according to claim 1, further comprising calculating capacity values of the cathode and the anode and an internal resistance value for each one of an assembled battery and a battery cell that constitute the battery.

7. The calculation method according to claim 1, further comprising:

   calculating any of a capacity of a first active material of a cathode, a capacity of a second active material of the cathode, a capacity of an anode, a charge amount of the first active material of the cathode, a charge amount of the second active material of the cathode, and a charge amount of the anode; and
   calculating, using the calculated value, at least one of a change characteristic of the charging voltage to a time, a characteristic of a potential of the cathode to the charge amount, and a characteristic of a potential of the anode to the charge amount.

8. The calculation method according to claim 1, wherein an anode includes lithium titanate as the active material.

9. A calculation apparatus (10), comprising:

a detection value database configured to store a charge amount of a battery and a voltage of the battery, the voltage being generated when the battery is charged, while associating the charge amount of the battery with the voltage of the battery;
a function information database (163) configured to store a function representing a relationship between an electrode potential and a charge amount of each of a plurality of active materials included in the battery; and
a computation unit configured to perform, by referring to the detection value database and the function information database (163), a regression calculation on the voltage of the battery that is stored in the detection value database, with capacities of active materials of electrodes, charge amounts of the active materials of the electrodes and an internal resistance value of the function stored in the function information database (163) being set as variables, for determining a degree of deterioration of the battery.

10. The calculation apparatus (10) according to claim 9, wherein

the battery includes at least one of a cathode including the plurality of active materials and an anode including the plurality of active materials, and
the computation unit refers to a function information database (163) configured to store a function representing a relationship between a potential of the plurality of active materials and a charge amount and calculates at least one of a cathode potential of the cathode including the plurality of active materials and an anode potential of the anode including the plurality of active materials.

11. The calculation apparatus (10) according to claim 9, wherein an anode includes lithium titanate as the active material.

12. The calculation apparatus (10) according to claim 9, wherein
the computation unit calculates any of a capacity of a first active material of a cathode, a capacity of a second active material of the cathode, a capacity of an anode, a charge amount of the first active material of the cathode, a charge amount of the second active material of the cathode, and a charge amount of the anode and calculates, using the calculated value, at least one of a change characteristic of the charging voltage to a time, a characteristic of a potential of the cathode to the charge amount, and a characteristic of a potential of the anode to the charge amount.

**Patentansprüche**

1. Berechnungsverfahren zum Berechnen eines Alterungsgrads einer Batterie, wobei das Berechnungsverfahren **dadurch gekennzeichnet ist, dass** es umfasst:

Verweisen auf

eine Detektionswert-Datenbank, die dazu ausgestaltet ist, eine Lademenge einer Batterie und eine Spannung der Batterie zu speichern, wobei die Spannung erzeugt wird, wenn die Batterie geladen wird, und dabei Verknüpfen der Lademenge der Batterie mit der Spannung der Batterie, und
eine Funktionsinformationsdatenbank (163), die dazu ausgestaltet ist, eine Funktion zu speichern, die eine Beziehung zwischen einem Elektrodenpotential und einer Lademenge von jedem von mehreren aktiven Materialien, die in der Batterie enthalten sind, darstellt; und

Bestimmen eines Alterungsgrads der Batterie durch Durchführen einer Regressionsberechnung (S102) auf der Spannung der Batterie, die in der Detektionswert-Datenbank gespeichert ist, wobei Kapazitäten von aktiven Materialien von Elektroden, Lademengen der aktiven Materialien der Elektroden und ein Innenwiderstandswert der in der Funktionsinformationsdatenbank (163) gespeicherten Funktion als Variablen eingestellt werden.

2. Berechnungsverfahren nach Anspruch 1, das ferner das Berechnen einer Zeitkennlinie einer Ladespannung der Batterie umfasst, wobei ein Innenwiderstandswert der Batterie und die Lademenge der Batterie während eines Zeitraums von einem Beginn des Ladens zu einer Detektion davon als Variablen eingestellt werden, wobei die Lademenge basierend auf dem Ladestromwert erhalten wird.

3. Berechnungsverfahren nach Anspruch 1, das ferner das Berechnen einer Zeitkennlinie einer Ladespannung der Batterie umfasst, wobei eine Lademenge der Lademenge der aktiven Materialien als eine Variable eingestellt wird.

4. Berechnungsverfahren nach Anspruch 2, wobei

der Ladestromwert einen Stromwert an einem Zeitpunkt des Konstantstromladens umfasst.

5. Berechnungsverfahren nach Anspruch 1, wobei

die Batterie mindestens eines von einer Kathode, welche die mehreren aktiven Materialien umfasst, und einer Anode umfasst, welche die mehreren aktiven Materialien umfasst,
das Berechnungsverfahren ferner umfasst:

Verweisen auf eine Funktionsinformationsdatenbank (163), die dazu ausgestaltet ist, eine Funktion zu speichern, die eine Beziehung zwischen einem Potential der mehreren aktiven Materialien und einer Lademenge darstellt, und
Berechnen mindestens eines von einem Kathodenpotential der Kathode, welche die mehreren aktiven Materialien umfasst, und einem Anodenpotential der Anode, welche die mehreren aktiven Materialien umfasst.

6. Berechnungsverfahren nach Anspruch 1, das ferner das Berechnen von Kapazitätswerten der Katode und der Anode und eines Innenwiderstandswerts für jede von einer zusammengebauten Batterie und einer Batteriezelle, welche die Batterie bilden, umfasst.

7. Berechnungsverfahren nach Anspruch 1, das ferner Folgendes umfasst:

Berechnen einer beliebigen von einer Kapazität eines ersten aktiven Materials einer Kathode, einer Kapazität eines zweiten aktiven Materials der Kathode, einer Kapazität einer Anode, einer Lademenge des ersten aktiven Materials der Kathode, einer Lademenge des zweiten aktiven Materials der Kathode und einer Lademenge der Anode; und
Berechnen, unter Verwendung des berechneten Werts, von mindestens einem von einer Änderungskennlinie der Ladespannung zu einer Zeit, einer Kennlinie eines Potentials der Kathode zur Lademenge und einer Kennlinie eines Potentials der Anode zur Lademenge.

8. Berechnungsverfahren nach Anspruch 1, wobei eine Anode Lithiumtitanat als das aktive Material umfasst.

9. Berechnungsvorrichtung (10), die umfasst:

eine Detektionswert-Datenbank, die dazu ausgestaltet ist, eine Lademenge einer Batterie und eine Spannung der Batterie zu speichern, wobei die Spannung erzeugt wird, wenn die Batterie geladen wird, und dabei Verknüpfen der Lademenge der Batterie mit der Spannung der Batterie;
eine Funktionsinformationsdatenbank (163), die dazu ausgestaltet ist, eine Funktion zu speichern, die eine Beziehung zwischen einem Elektrodenpotential und einer Lademenge von jedem von mehreren aktiven Materialien darstellt, die in der Batterie enthalten sind, und
eine Berechnungseinheit, die dazu ausgestaltet ist, durch Verweisen auf die Detektionswert-Datenbank und die Funktionsinformationsdatenbank (163) eine Regressionsberechnung auf der Spannung der Batterie durchzuführen, die in der Detektionswertdatenbank gespeichert ist, wobei Kapazitäten von aktiven Materialien von Elektroden, Lademengen der aktiven Materialien der Elektroden und ein Innenwiderstandswert der Funktion, die in der Funktionsinformationsdatenbank (163) gespeichert ist, als Variablen zum Bestimmen eines Alterungsgrads der Batterie eingestellt werden.

10. Berechnungsvorrichtung (10) nach Anspruch 9, wobei

die Batterie mindestens eines von einer Kathode, welche die mehreren aktiven Materialien umfasst, und einer Anode umfasst, welche die mehreren aktiven Materialien umfasst, und
die Berechnungseinheit auf eine Funktionsinformationsdatenbank (163) verweist, die dazu ausgestaltet ist, eine Funktion zu speichern, die eine Beziehung zwischen einem Potential der mehreren aktiven Materialien und einer Lademenge darstellt, und mindestens eines von einem Kathodenpotential der Kathode, welche die mehreren aktiven Materialien umfasst, und einem Anodenpotential der Anode berechnet, welche die mehreren aktiven Materialien umfasst.

11. Berechnungsvorrichtung (10) nach Anspruch 9, wobei eine Anode Lithiumtitanat als das aktive Material umfasst.

**12.** Berechnungsvorrichtung (10) nach Anspruch 9, wobei
die Berechnungseinheit ein beliebiges von einer Kapazität eines ersten aktiven Materials einer Kathode, einer Kapazität eines zweiten aktiven Materials der Kathode, einer Kapazität einer Anode, einer Lademenge des ersten aktiven Materials der Kathode, einer Lademenge des zweiten aktiven Materials der Kathode und einer Lademenge der Anode berechnet und unter Verwendung des berechneten Werts mindestens eines von einer Änderungskennlinie der Ladespannung zu einer Zeit, einer Kennlinie eines Potentials der Kathode zu der Lademenge und einer Kennlinie eines Potentials der Anode zu der Lademenge berechnet.

**Revendications**

**1.** Procédé de calcul pour calculer un degré de détérioration d'une batterie, le procédé de calcul étant **caractérisé en ce qu'**il comprend :

la référence à

une base de données de valeurs de détection configurée pour stocker une quantité de charge d'une batterie et une tension de la batterie, la tension étant générée lorsque la batterie est chargée, tout en associant la quantité de charge de la batterie à la tension de la batterie, et
une base de données d'informations de fonction (163) configurée pour stocker une fonction représentant une relation entre un potentiel d'électrode et une quantité de charge de chacun d'une pluralité de matériaux actifs inclus dans la batterie ; et

la détermination d'un degré de détérioration de la batterie par la réalisation d'un calcul de régression (S102) sur la tension de la batterie qui est stockée dans la base de données de valeurs de détection, avec des capacités de matériaux actifs d'électrodes, des quantités de charge des matériaux actifs des électrodes et une valeur de résistance interne de la fonction stockée dans la base de données d'informations de fonction (163) étant définies en tant que variables.

**2.** Procédé de calcul selon la revendication 1, comprenant en outre le calcul d'une caractéristique de temps d'une tension de charge de la batterie, avec une valeur de résistance interne de la batterie et la quantité de charge de la batterie au cours d'une période de temps depuis un début de charge jusqu'à une détection de celle-ci étant définies en tant que variables, la quantité de charge étant obtenue sur la base d'une valeur de courant de charge.

**3.** Procédé de calcul selon la revendication 1, comprenant en outre le calcul d'une caractéristique de temps d'une tension de charge de la batterie, avec une quantité de changement de la quantité de charge des matériaux actifs étant définie en tant que variable.

**4.** Procédé de calcul selon la revendication 2, dans lequel
la valeur de courant de charge inclut une valeur de courant à un temps de charge de courant constant.

**5.** Procédé de calcul selon la revendication 1, dans lequel

la batterie inclut au moins l'une d'une cathode incluant la pluralité de matériaux actifs et d'une anode incluant la pluralité de matériaux actifs,
le procédé de calcul comprenant en outre
la référence à une base de données d'informations de fonction (163) configurée pour stocker une fonction représentant une relation entre un potentiel de la pluralité de matériaux actifs et une quantité de charge, et le calcul d'au moins l'un d'un potentiel de cathode de la cathode incluant la pluralité de matériaux actifs et d'un potentiel d'anode de l'anode incluant la pluralité de matériaux actifs.

**6.** Procédé de calcul selon la revendication 1, comprenant en outre le calcul de valeurs de capacité de la cathode et de l'anode et d'une valeur de résistance interne pour chacune d'une batterie assemblée et d'une cellule de batterie constituant la batterie.

**7.** Procédé de calcul selon la revendication 1, comprenant en outre :

le calcul de n'importe laquelle d'une capacité d'un premier matériau actif d'une cathode, d'une capacité d'un deuxième matériau actif de la cathode, d'une capacité d'une anode, d'une quantité de charge du premier matériau actif de la cathode, d'une quantité de charge du deuxième matériau actif de la cathode, et d'une quantité de charge de l'anode ; et

le calcul, en utilisant la valeur calculée, d'au moins l'une d'une caractéristique de changement de la tension de charge à un temps, d'une caractéristique d'un potentiel de la cathode à la quantité de charge, et d'une caractéristique d'un potentiel de l'anode à la quantité de charge.

8. Procédé de calcul selon la revendication 1, dans lequel une anode inclut du titanate de lithium en tant que matériau actif.

9. Appareil de calcul (10), comprenant :

une base de données de valeurs de détection configurée pour stocker une quantité de charge d'une batterie et une tension de la batterie, la tension étant générée lorsque la batterie est chargée, tout en associant la quantité de charge de la batterie à la tension de la batterie ;

une base de données d'informations de fonction (163) configurée pour stocker une fonction représentant une relation entre un potentiel d'électrode et une quantité de charge de chacun d'une pluralité de matériaux actifs inclus dans la batterie ; et

une unité de calcul configurée pour réaliser, en faisant référence à la base de données de valeurs de détection et à la base de données d'informations de fonction (163), un calcul de régression sur la tension de la batterie qui est stockée dans la base de données de valeurs de détection, avec des capacités de matériaux actifs d'électrodes, des quantités de charge des matériaux actifs des électrodes et une valeur de résistance interne de la fonction stockée dans la base de données d'informations de fonction (163) étant définies en tant que variables, pour déterminer un degré de détérioration de la batterie.

10. Appareil de calcul (10) selon la revendication 9, dans lequel

la batterie inclut au moins l'une d'une cathode incluant la pluralité de matériaux actifs et d'une anode incluant la pluralité de matériaux actifs, et

l'unité de calcul fait référence à une base de données d'informations de fonction (163) configurée pour stocker une fonction représentant une relation entre un potentiel de la pluralité de matériaux actifs et une quantité de charge et calcule au moins l'un d'un potentiel de cathode de la cathode incluant la pluralité de matériaux actifs et d'un potentiel d'anode de l'anode incluant la pluralité de matériaux actifs.

11. Appareil de calcul (10) selon la revendication 9, dans lequel une anode inclut du titanate de lithium en tant que matériau actif.

12. Appareil de calcul (10) selon la revendication 9, dans lequel
l'unité de calcul calcule n'importe laquelle d'une capacité d'un premier matériau actif d'une cathode, d'une capacité d'un deuxième matériau actif de la cathode, d'une capacité d'une anode, d'une quantité de charge du premier matériau actif de la cathode, d'une quantité de charge du deuxième matériau actif de la cathode, et d'une quantité de charge de l'anode et calcule, en utilisant la valeur calculée, au moins l'une d'une caractéristique de changement de la tension de charge à un temps, d'une caractéristique d'un potentiel de la cathode à la quantité de charge, et d'une caractéristique d'un potentiel de l'anode à la quantité de charge.

FIG. 1

FIG. 2

FIG. 3

FIG. 4

FIG. 5

FIG. 6

START

S101 — STORE DETECTION VALUE DATA
AND DETECTION TIME DATA

S102 — CALCULATE CHARGING VOLTAGE ETC.
BY REGRESSION CALCULATION

(S103) — STORE CALCULATED
CHARGING VOLTAGE ETC.

(S104) — COMPARE CALCULATED CHARGING
VOLTAGE WITH FUNCTION DATA TO
CALCULATE STATE OF BATTERY

RETURN TO START

## FIG. 7

STEP S101                                          S102

S1021 — SET INITIAL VALUES

S1022 — GENERATE SYSTEM OF
SIMULTANEOUS EQUATIONS
(DETERMINANT)

S1025

S1023 — CALCULATE
SOLUTION OF SYSTEM OF
SIMULTANEOUS EQUATIONS

RESET INITIAL VALUES

S1024   WITHIN
RADIUS OFCONVERGENCE?        NO

YES

STEP S103

## FIG. 8

24

FIG. 9

FIG. 10

FIG. 11

FIG. 12

FIG. 13

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011122965 A
- JP 2011075461 A

- US 2010121591 A1